# EUROPÄISCHE PATENTANMELDUNG

(11) **EP 1 626 503 A2**
(43) Veröffentlichungstag der Anmeldung: **15.02.2006**
(21) Anmeldenummer: 05010465.2
(22) Anmeldetag: 13.05.2005
(51) Int. Cl.: H03M 3/00

(54) **Rauschformerschaltung und Verfahren zum Reduzieren eines Schaltgeräusches**

(30) Priorität: 11.08.2004 DE 102004039725
(71) Anmelder: Micronas GmbH, 79108 Freiburg (DE)
(72) Erfinder: Pfister, Florian, Dipl.-Ing. (FH), 79331 Teningen (DE); Lücking, Dieter, Dipl.-Ing. (FH), 79110 Freiburg (DE); Vierthaler, Matthias, Dipl.-Ing., 79211 Denzlingen (DE); Noeske, Carsten, Dipl.-Ing., 79350 Sexau (DE)
(74) Vertreter: Göhring, Robert

(57) **Zusammenfassung**

Die Erfindung bezieht sich auf ein Verfahren zum Reduzieren eines Schaltgeräusches beim Schalten eines Rauschformers (H), wobei das Schalten in einen inaktiven Zustand erst nach dem Erfassen von einer Mindestanzahl (n) von Daten (d; d*; d°) unterhalb eines Schwellenwerts (t) oder Daten gleich eines bestimmten Wertes bzw. Pegels oder von einer Mindestanzahl (n) von Daten, welche innerhalb eines Schwellenbereichs um einen bezüglich der Daten zueinander konstanten Wert liegen, durchgeführt wird. Entsprechend wird vorgeschlagen eine Rauchformerschaltung (NS) mit einer Schalteinrichtung zum Schalten eines Rauschformers (H) in einen inaktiven Zustand nach Erfassen eines Schaltkriteriums, wobei die Schalteinrichtung zum Erfassen einer Mindestanzahl (n) von Daten (d; d*; d°) unterhalb eines Schwellenwerts (t) oder gleich eines bestimmten Wertes bzw. Pegels oder von Daten (d; d*; d°), die innerhalb eines Schwellenbereichs um einen hinsichtlich aufeinanderfolgender Daten zueinander konstanten Wert liegen, als Schaltkriterium ausgelegt ist.

## Beschreibung

Die Erfindung bezieht sich auf ein Verfahren zum Reduzieren eines Schaltgeräusches beim Schalten eines Rauschformers mit den oberbegrifflichen Merkmalen des Patentanspruchs 1 bzw. auf eine Rauschformerschaltung mit den oberbegrifflichen Merkmalen des Patentanspruchs 8.

Bei der Verarbeitung von Eingangsdaten in einer Daten-Verarbeitungseinrichtung, beispielsweise einem Digital/Analogwandler oder einem Impulsbreiten-Modulations-Wandler, ist der Einsatz eines Rauschformers (engl.: noise shaper) vorteilhaft, mit dem das Signal-zu-Rausch-Verhältnis mit Blick auf das Hintergrundrauschen in einem gewünschten Bereich verändert wird. Dabei wird das Hintergrundrauschen in den tieferen Frequenzbereich durch Verschiebung von Anteilen der Signalenergie zu höheren Frequenzen, welche nicht benötigt werden, insbesondere nicht hörbar sind, reduziert. Der Einsatz findet insbesondere in Systemen statt, in denen eine Amplitudenquantisierung durchgeführt wird.

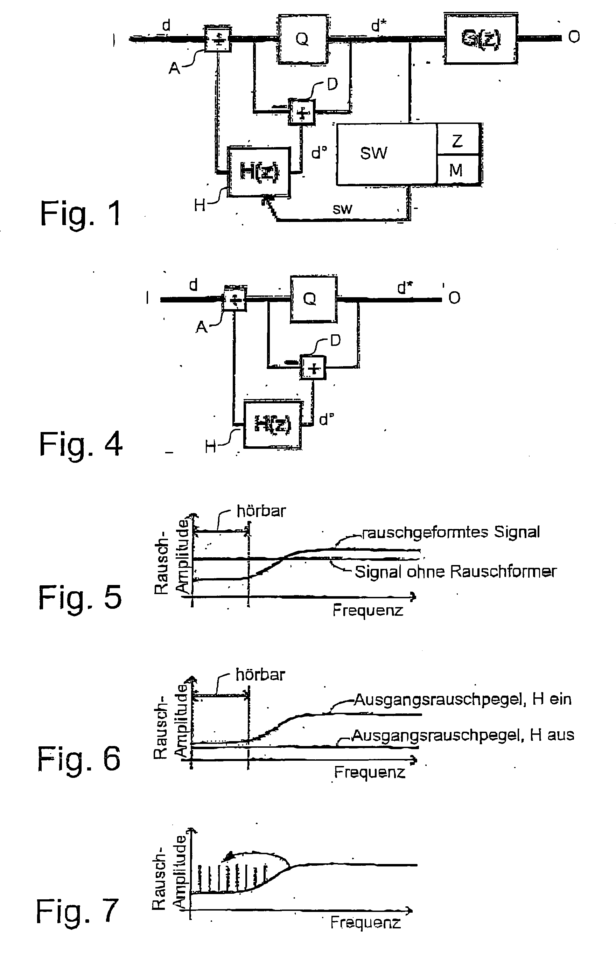

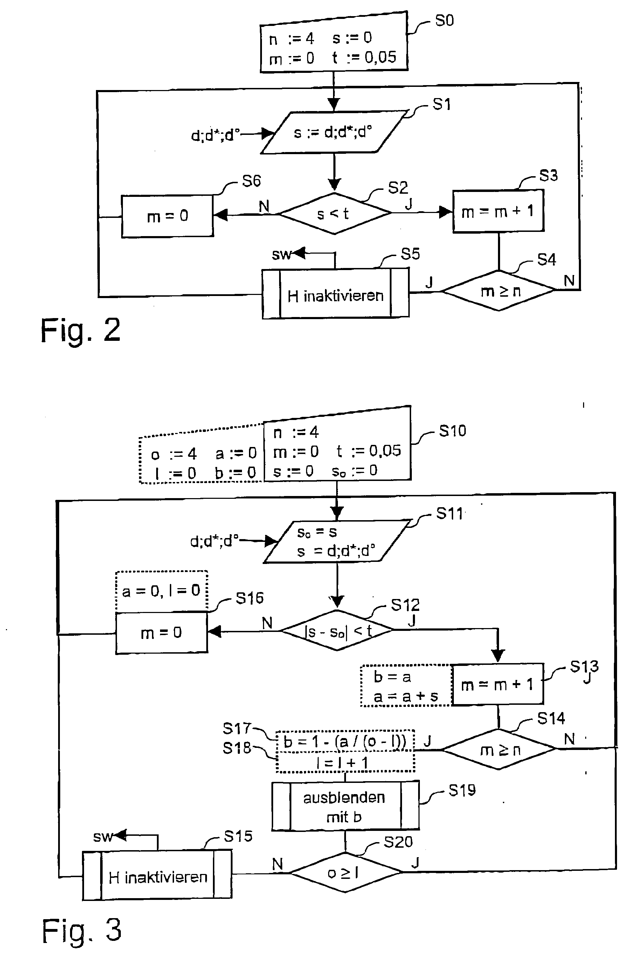

Fig. 4 zeigt eine beispielhafte allgemeine Schaltungsanordnung mit einem Rauschformer. Von einem Eingang I aus werden ein Signal bzw. Eingangsdaten d einer Datenfolge einer Daten-Verarbeitungseinrichtung Q zugeführt. Die in der Daten-Verarbeitungseinrichtung Q verarbeiteten Daten d* werden von der Daten-Verarbeitungseinrichtung Q einem Ausgang O zugeführt. Von den verarbeiteten Daten d* wird ein Datenwert subtrahiert, welcher vor der Daten-Verarbeitungseinrichtung Q von den Eingangsdaten d abgegriffen wird. Das Subtraktionsergebnis bildet ein Fehlersignal d°, welches als Rauschformer-Eingangssignal d° dem eigentlichen Rauschformer H zugeführt wird. Dessen Ausgangssignal wird den Eingangsdaten d mittels eines Addierers A aufaddiert bzw. ggf, davon subtrahiert. Im Fall eines Rauschfilters erster Ordnung wird das Fehlersignal d° direkt dem Addierer A zugeführt. Der typische Rauschformer H wird durch ein digitales Hochpassfilter H(z) ausgebildet, welches auf einer Verzögerungsanordnung bzw. Verzögerungsleitung basiert. Wenn an dem Rauschformer H ein Eingangswert d° angelegt wird, der ungleich Null ist, beginnt der Rauschformer H einen Ausgangswert zu erzeugen, wobei solche Ausgangswerte mit einem Mittelwert der Amplitude der Eingangsdaten erzeugt werden.

Fig. 5 zeigt beispielhaft die Rausch-Amplitude über der Frequenz für ein zu verarbeitendes Signal d, wobei im Fall ohne den Rauschformer eine gleichmäßige Rauschamplitude über alle Frequenzen erhalten wird. Für den Fall des Einsatzes des Rauschformers werden rauschgeformte Ausgangsdaten d* erhalten, deren Signal-zu-Rausch-Verhältnis in einem gewünschten Bereich, insbesondere in einem hörbaren Bereich eine reduzierte Rauschamplitude und in einem höher frequenten Bereich eine erhöhte Rauschamplitude aufweist. Wenn Parameter des Rauschformers geändert werden, bewirkt dies stets, dass das Spektrum des Rauschens geändert wird.

Falls kein Eingangssignal am Eingang I der Verarbeitungseinrichtung Q erfasst wird, kann das Signal-zu-Rausch-Verhältnis durch das Ausschalten des Rauschformers weiter verbessert werden. Das Ausschalten bzw. Schalten in einen inaktiven zustand des Rauschformers H führt zu einem robusten Ausgangssignal des Rauschformers, welches keine weiteren Rauschkomponenten mehr erzeugt. Fig. 6 zeigt den reduzierten Rauschpegel der Ausgangsdaten für den Fall des ausgeschalteten Rauschformers H gegenüber dem im gesamten Spektrum ungünstigeren Rauschpegel des Ausgangssignals bei eingesdhaltetem Rauschformer H.

Nachteilhafterweise führt das Ausschalten bzw. Inaktivieren des Rauschformers H zu Schaltgeräuschen, welche auch als Click bezeichnet werden. Die Schaltgeräusche entstehen durch die Nicht-Linearität einer Impulsfunktion, wenn ein Signal bzw. eine Abfolge von Daten einer Datenfolge ausgeschaltet wird.

Ein solches Schaltgeräusch hat dabei nichts mit einer Gleichspannungskomponente (DC) zu tun, denn das Schaltgeräusch entsteht auch, wenn das mittlere Signal am Rauschformerausgang Null ist. Das Schaltgeräusch entsteht durch den Tiefpasscharakter des Gehörs, wenn plötzlich eine vorhandene Signalenergie mit dem Mittelwert Null zu einer Null-Signalenergie geschaltet wird. Dieser Schaltvorgang erzeugt kurzfristig Frequenzen im gesamten spektrum, somit auch im Nutzerfrequenzband. Bei herkömmlichen Rauschformern besteht somit das Problem, den Rauschformer derart auszuschalten oder eine spezifische Struktur derart innerhalb des Rauschformers zu erzeugen, dass nur ein reduziertes Schaltgeräusch beim Ausschalten bzw. Inaktivieren erzeugt wird.

Die meisten bekannten Techniken betreffen Rauschformer mit einem Einzelbit-Ausgang. Daher ist die Umsetzung zu einem Mehrbit-Rauschformer nicht in jedem Fall möglich.

Aus US 5200750 ist eine Schaltung bekannt, bei welcher ein zusätzliches Eingangssignal dem Rauschformer zugeführt wird, um die Rauschformerstruktur zu stabilisieren. Wenn die Struktur stabilisiert ist, kann der Rauschformer ausgeschaltet werden. Zur Umsetzung ist eine sehr komplexe Schaltungsanordnung und Verfahrensweise erforderlich.

Aus US 5712874 ist eine Schaltungsanordnung mit einem Tiefpass-Filter für einen ersten Integrator des Rauschformers bekannt, um das Rauschformersignal bzw. die Rauschformerdatenfolge automatisch zu stabilisieren. Eine Implementierung für einen Mahrbit-Rauschformer erscheint nicht möglich. Das Schalten eines Tiefpass-Filters verursacht außerdem eine Schaltgeräuschamplitude, welche wesentlich größer als die ursprungliche Schaltgeräuschamplitude ist.

Gemäß einer These von Thomas H. Hansen, Muting of Noise-Shaper Quantized Signals, Seite 77 - 94, 6. Mai 2003, wird ein Rauschformer aufgrund einer Vorhersage der zu erwartenden spezifischen Energie gestoppt. Vorgeschlagen wird dabei ein Verfahren zum Reduzieren unerwünschter inbandiger Transienten beim Stoppen eines Rauschformersignals. Bei diesem Verfahren soll ein Detektor als Schalteinrichtung zum Steuern des Moments verwendet werden, zu dem das quantisierte Signal auf Null gesetzt wird. Für die Schalteinrichtung zum Stoppen des Rauschformers wird ein Modell des Rauschformers verwendet, auf dessen Basis eine Vorhersage des Abschaltzeitpunktes gemacht wird.

Die Aufgabe der Erfindung besteht darin, ein alternatives Verfahren zum Reduzieren eines Schaltgeräusches beim Schalten eines Rauschformers bzw. eine alternative Rauschformerschaltung mit einem Rauschformer und einer Schalteinrichtung zum Inaktivieren des Rauschformers vorzuschlagen.

Diese Aufgabe wird durch ein Verfahren mit den Merkmalen des Patentanspruchs 1 bzw. durch eine Rauschformerschaltung mit den Merkmalen des Patentanspruchs 8 gelöst. Vorteilhafte Ausgestaltungen sind Gegenstand abhängiger Ansprüche.

Bevorzugt wird demgemäss ein Verfahren zum Reduzieren eines Schaltgeräuschs beim Schalten.eines Rauschformers, wobei das Schalten in einen inaktiven Zustand erst nach dem Erfassen von einer Mindestanzahl von Daten unterhalb eines Schwellenwerts oder Daten gleich eines bestimmten Wertes bzw. Pegels oder von einer Mindestanzahl von Daten, welche innerhalb eines Schwellenbereichs um einen bezüglich der Daten zueinander konstanten Wert liegen, durchgeführt wird. Vorrichtungsgemäß wird besonders bevorzugt eine Rauschformerschaltung mit einer Schalteinrichtung zum Schalten eines Rauschformers in einen inaktiven Zustand nach Erfassen eines Schaltkriteriums, wobei die Schalteinrichtung zum Erfassen einer Mindestanzahl von Daten unterhalb eines Schwellenwerts oder gleich eines bestimmten Wertes bzw. Pegels oder von Daten, die innerhalb eines Schwellenbereichs um einen hinsichtlich aufeinanderfolgender Daten zueinander konstanten Wert liegen, als Schaltkriterium ausgelegt ist.

Die Rauschformerschaltung kann dabei aus einer Vielzahl einzelner Komponenten oder mittels einer integrierten Schaltungsanordnung ausgebildet sein.

Unter dem Schalten wird ein allgemeiner Vorgang verstanden, welcher je nach Ausgestaltung ein aktives mechanisches oder elektrisches Schalten oder ein logisches Schalten bzw. Inaktivieren des Rauschformers bzw. der entsprechenden Verfahrensschritte eines Rauschformers umfasst.

Hervorzuheben sind insbesondere zwei zueinander unabhängige Schaltkriterien, welche gemäß besonders bevorzugter Ausgestaltung auch kombinierbar bzw. um weitere entsprechende Schaltkriterien üblicher Art erweiterbar sind. Demgemäss kann als Schaltkriterium angesetzt werden, dass die für das Schaltkriterium zu erfassenden Daten einen insbesondere konstanten Datenwert haben oder unterhalb eines Schwellenwerts liegen. Gemäß dem zweiten besonders hervorzuhebenden Kriteriums können die Daten auch innerhalb eines Schwellenbereichs um einen hinsichtlich einer Folge von Daten zueinander konstanten Wert liegen, so dass ein Schaltvorgang auch bei einer Abfolge von konstanten oder im wesentlichen konstanten Daten durchgeführt werden kann. Ein solcher Fall kann beispielsweise vorliegen, wenn ein monofrequentes Störgeräusch den Eingangsdaten überlagert ist, so dass diese im Fall ausbleibender Nutzdatenwerte, welche ungleich einem insbesondere konstanten Datenwert wären, trotzdem auf einem relativ hohen konstanten Wert verbleiben. Als Wert, insbesondere konstanter Datenwert kann neben einem Pegelwert ungleich Null insbesondere auch der Wert Null angesehen werden.

Weiterhin ist unter einer Folge von Daten bzw. unter der zu erfassenden Mindestanzahl von Daten nicht zwingend zu verstehen, dass jeweils alle einzelnen Datenwerte innerhalb der Folge von Daten dem Schaltkriterium unterliegen müssen, so dass auch im Fall von einzelnen Ausreißern das Schaltkriterium erfüllbar ist. Für das Schaltkriterium werden Daten verwendet, welche letztendlich an verschiedenen Punkten der gesamten Schaltungsanordnung erfasst werden können.

Besonders bevorzugt wird ein solches Verfahren zum Reduzieren eines Schaltgeräusches beim Schalten eines Rauschformers, bei dem an einen Eingang einer Daten-Verarbeitungseinrichtung angelegte Eingangsdaten durch den Rauschformer verändert werden und bei dem der Rauschformer fallweise inaktiv geschaltet wird, wobei in Verbindung mit dem Inaktivieren eine Reduzierung des Schaltgeräusches durchgeführt wird, wobei zum Reduzieren des Schaltgeräusches das Schalten erst nach dem Erfassen einer vorgegebenen Mindestanzahl von Daten unter dem Schwellenwert oder gleich einem insbesondere konstanten Datenwert durchgeführt wird. Besonders bevorzugt wird ein Verfahren gemäß der zweiten Variante bzw. in Kombination mit dem vorstehend aufgeführten Verfahren der ersten Variante zum Reduzieren eines Schaltgeräusches beim Schalten eines Rauschformers, bei dem an einen Eingang einer Daten-Verarbeitungseinrichtung angelegte Eingangsdaten durch den Rauschformer verändert werden und bei dem der Rauschformer fallweise inaktiv geschaltet wird, wobei in Verbindung mit dem,Inaktivieren eine Reduzierung des Schaltgeräusches durchgeführt wird, wobei zum Reduzieren des Schaltgeräusches das Schalten erst nach dem Erfassen einer vorgegebenen Mindestanzahl von Daten, welche innerhalb eines Schwellenbereichs um einen hinsichtlich einer Folge von Daten zueinander konstanten Wert liegen, durchgeführt wird.

Vorrichtungsgemäß entspricht diesem Verfahren gemäß der ersten Variante eine Rauschformerschaltung zum Verändern von Eingangsdaten einer Datenfolge für eine Daten-Verarbeitungseinrichtung mit einem Rauschformer und einer Schalteinrichtung zum Inaktivieren des Rauschformers und zum Reduzieren eines Schaltgeräusches, wobei die Schalteinrichtung einen Zähler zum Zählen von Daten unterhalb eines Schwellenwerts oder gleich einem konstanten Datenwert aufweist und die Schalteinrichtung zum Inaktivieren des Rauschformers erst nach Erfassen einer vorgegebenen Mindestanzahl der gezählten Daten unterhalb des Schwellenwerts oder gleich einem konstanten Datenwert ausgelegt ist. Gemäß der zweiten Variante entspricht dem vorrichtungsgemäß eine Rauschformerschaltung zum Verändern von Eingangsdaten einer Datenfolge für eine Daten-Verarbeitungseinrichtung mit einem Rauschformer und einer Schalteinrichtung zum Inaktivieren des Rauschformers und zum Reduzieren eines Schaltgeräusches, wobei die Schalteinrichtung einen Zähler zum Zählen von Daten innerhalb eines Schwellenbereichs um einen hinsichtlich zueinander benachbarten Daten konstanten Wert aufweist und die Schalteinrichtung zum Inaktivieren des Rauschformers erst nach Erfassen einer vorgegebenen Mindestanzahl der gezählten Daten innerhalb des Schwellenbereichs ausgelegt ist.

Bevorzugt wird ein solches Verfahren, bei dem die Mindestanzahl variabel vorgegeben wird, insbesondere abhängig von der Art oder Herkunft der Daten und/oder der Schwankungsbreite der Werte aufeinanderfolgender der Daten variabel vorgegeben wird. Dem entspricht eine solche Rauschformerschaltung, bei der die Schalteinrichtung ausgelegt ist, die Mindestanzahl variabel vorzugeben, insbesondere abhängig von der Art oder Herkunft der Daten und/oder abhängig von der Schwankungsbreite der Werte aufeinanderfolgender Daten variabel vorzugeben ausgelegt ist.

Bevorzugt wird ein solches Verfahren, bei welchem dem Rauschformer vor dem Schalten oder anstelle eines aktiven Schaltens über eine vorgegebene Anzahl von Daten ein separates Signal zum Inaktivieren zugeführt wird. Vorrichtungsgemäß entspricht dem eine solche Rauschformerschaltung, bei welcher der Rauschformer einen Eingang zum Zuführen eines separaten Signals zum Inaktivieren über eine vorgegebene Dauer bzw. Anzahl von Daten vor dem Schalten aufweist.

Bevorzugt wird ein solches Verfahren, bei welchem dem Rauschformer vor dem Schalten oder anstelle eines aktiven Schaltens vorverarbeitete Eingangsdaten angelegt werden, wobei die vorverarbeitung zum allmählichen Reduzieren einer Datenamplitude über eine Anzahl von Daten durchgeführt wird. Vorrichtungsgemäß entspricht dem eine solche Rauschformerschaltung, bei welcher der Rauschformer ausgelegt ist, vor dem Schalten vorverarbeitete Eingangsdaten aufzunehmen, wobei die vorverarbeiteten Eingangsdaten zum allmählichen Reduzieren einer Datenamplitude über eine vorgegebene Anzahl von Daten bereitgestellt werden. Dies ermöglicht ein Ausblenden für den Fall, dass die erfassten Daten nicht gleich einem konstanten Datenwert oder oberhalb eines zum Ausschalten unerwünschten Wertes liegen, so dass nach dem Erfassen einer das Schaltkriterium erfüllenden Mindestanzahl von Daten vor dem eigentlichen Schalten bzw. Inaktivieren des Rauschformers über eine weitere Abfolge von Daten bzw. eine weitere Zeitdauer eine Reduzierung der Datenwerte und/oder der im Rauschformer erzeugten Werte oder Variablen durchgeführt wird.

Bevorzugt wird ein Verfahren, bei welchem nach dem Erfassen einer vorgegebenen Mindestanzahl von Daten am Eingang des Rauschformers unter dem Schwellenwert oder gleich eines bestimmten Wertes eine Erfassung von Ausgangswerten gestartet wird und das Schalten und/oder ein Zurücksetzen des Rauschformers nach dem Erfassen einer vorgegebenen Mindestanzahl von Daten unter einem Schwellenwert oder gleich eines bestimmten Wertes am Ausgang des Rauschformers durchgeführt wird. Das Zurücksetzen erfolgt insbesondere auf Null oder einen fest vorgegebenen Wert, z.B. auf 0,5.

Bevorzugt werden ein solches Verfahren oder eine solche Rauschformerschaltung, wobei die erfassten Daten von dem' Rauschformer veränderte oder von dem Rauschformer unveränderte Eingangsdaten für die Daten-Verarbeitungseinrichtung sind. Alternativ oder in Kombination werden bevorzugt ein solches Verfahren bzw. eine solche Rauschformerschaltung, wobei die erfassten Daten Ausgangsdaten der Daten-Verarbeitungseinrichtung sind. Bevorzugt werden außerdem ein solches Verfahren bzw. eine solche Rauschformerschaltung, wobei die erfassten Daten Rauschformer-Eingangsdaten am Eingang des Rauschformers sind. In einem solchen Fall wird besonders bevorzugt ein solches Verfahren bzw. eine solche Rauschformerschaltung, wobei die erfassten Daten aus Eingangsdaten und Ausgangsdaten der Daten-Verarbeitungseinrichtung gebildet werden.

Vorzugsweise finden ein solches Verfahren oder eine solche Rauschformerschaltung Anwendung in Verbindung mit einer Daten-Verarbeitungseinrichtung in Form eines Digital/Analog-Wandlers oder eines Impulsbreiten-Modulations-Wandlers.

Bevorzugt werden ein Verfahren bzw. eine Rauschformerschaltung, bei denen die Anzahl der erfassten Werte oder Daten kaskadiert reduziert wird, wenn der Rauschformer eine bestimmte Zeit lang nicht zurück gesetzt oder geschaltet wurde.

Verfahrensgemäß bzw. vorrichtungsgemäß wird demgemäss davon ausgegangen, dass die Energie eines Schaltgeräusches bzw. Klicks geringer sein wird, wenn die vom Rauschformer ausgegebenen Daten bereits über eine bestimmte Zeitdauer bzw. Abfolge von Datenwerten Null, nahe Null oder nahe eines konstanten Wertes waren, bevor der Schaltvorgang durchgeführt wird. Bestimmt wird somit ein vorteilhafter Zeitpunkt für den Schaltvorgang. Da der Rauschformer in zeitlichen Abständen, beispielsweise bei einer Pause von Musiktiteln einer Kompaktplatte (CD) Daten mit Nullwerten ausgibt bzw. auch die Eingangsdaten der Anordnung oder die Ausgangsdaten der Verarbeitungseinrichtungen über eine Zeit lang Nullwerte ausgeben, wirkt sich dies auf die Energie aus, welche in den Impulsen steckt, welche beim Schaltvorgang im gesamten Spektrum erzeugt werden.

Ein Ausführungsbeispiel wird nachfolgend anhand der Zeichnung näher erläutert, Es zeigen:
- Fig. 1: eine beispielhafte Rauschformerschaltung mit einem Rauschformer und einer Datenverarbeitungseinrichtung;
- Fig. 2: ein beispielhaftes Ablaufdiagramm zum Durchführen eines Verfahrens zum Bestimmen eines Schaltzeitpunkts zum Inaktivieren eines Rauschformers;
- Fig. 3: ein Ablaufdiagramm eines damit kombinierbaren oder dazu alternativen Verfahrens;
- Fig. 4: eine für sich bekannte Rauschformerschaltung; und
- Fig. 5-7: Diagramme zum Veranschaulichen von signal- und Rauschverhältnissen im Fall des Einsatzes oder nicht vorgenommenen Einsatzes eines Rauschformers.

Fig. 1 zeigt eine beispielhafte Rauschformerschaltung NS in Verbindung mit einer Daten-Verarbeitungseinrichtung Q und einer Schalteinrichtung SW zum Schalten eines eigentlichen Rauschformers H. Eine Übertragung auf andere für sich bekannte Anordnungen von Komponenten oder eine verfahrenstechnische Umsetzung in einem Prozessor, insbesondere in einer integrierten Schaltung ist entsprechend umsetzbar.

Die Schaltungsanordnung weist eigen Eingang I auf, an welchem Eingangsdaten d einer Datenfolge bzw. eines Signals angelegt werden. Der Eingang I ist über einen Addierer A mit der Daten-Verarbeitungseinrichtung Q zum Zuführen der Eingangsdaten d verbunden. Die Eingangsdaten mit einem ggf. im Addierer aufaddierten bzw. subtrahierten Wert werden in der Daten-Verarbeitungseinrichtung Q verarbeitet. Beispielhafte DatenVerarbeitungseinrichtungen Q sind ein Digital/Analog-Wandler oder ein Impulsbreiten-Modulations-Wandler. Beispielsweise wird durch die Daten-Verarbeitungseinrichtung eine Umsetzung eines 16-Bit-Signals am Eingang I auf ein auszugebendes 5-Bit-Signal durchgeführt. Ausgangsdaten d* der Daten-Verarbeitungseinrichtung Q werden direkt einem!Ausgang O oder, wie dargestellt, über eine oder mehrere weitere Einrichtungen G(z) dem Ausgang 0 zugeführt. Die weitere Verarbeitungseinrichtung G(z) ist beispielsweise ein Tiefpassfilter, welcher zum Bestimmen einer Schaltgeräuschamplitude verwendet wird, um die Auswirkung der Gesamtschaltungsanordnung auf Schaltgeräusche zu prüfen.

Vom Ausgang der Daten-Verarbeitungseinrichtung Q ausgegebene Daten d* werden außerdem einem Subtrahierer D zugeführt, um von diesen Ausgangsdaten d* über eine weitere Verbindungsleitung angelegte direkte Eingangsdaten der Daten-Verarbeitungseinrichtung Q zu subtrahieren. Die Verbindungsleitung greift entsprechend die Leitung zwischen dem Addierer A und der Daten-Verarbeitungseinrichtung Q ab. Ein Ausgang des Subtrahierers D ist mit einem Eingang des eigentlichen Rauschformers H zum Übertragen von Rauschformer-Eingangsdaten d° verbunden. Der Rauschformer H kann in üblicher Art und Weise aufgebaut sein und wird beispielsweise durch ein Hochpass-Filter H(z) mit einer Anordnung aus Verzögerungsgliedern ausgebildet. Das Ausgangssignal des Rauschformers H wird über eine Leitung dem zweiten Eingang des Addierers A angelegt und zum Addieren mit den Eingangsdaten d verwendet.

Zum Schalten des Rauschformers H wird die Schalteinrichtung SW verwendet. Diese umfasst insbesondere einen Zähler Z sowie ggf. einen Speicher M zum Speichern von Zählwerten und vorgegebenen Variablen. Die Schalteinrichtung SW erzeugt ein Schaltsignal sw zum Rücksetzen des Rauschformers H und/oder zum Schalten des Rauschformers H in einen inaktiven Zustand, wenn keine zu verarbeitenden Eingangsdaten d in die Schaltungsanordnung eingegeben werden !oder in dieser verarbeitet werden. Das Schaltsignal sw wird über eine entsprechende Leitung von der Schalteinrichtung SW an einen Schalteingang des Rauschformers H zu dessen Inaktivierung bzw. zeitweiliger Inaktivierung angelegt. Gemäß alternativer Ausführungsformen können auch die dem Rauschformer zuzuführenden Rauschformer-Eingangsdaten d° zuerst der Schalteinrichtung SW zugeführt werden, um diese Rauschformer-Eingangsdaten in der Schalteinrichtung SW zu verarbeiten oder vorzuverarbeiten. Das Zurücksetzen des Rauschformers H, insbesondere des Hochpass-Filters H(z), erfolgt insbesondere durch ;gleichzeitiges Zurücksetzen aller Speicher darin.

Ein Eingang der Schalteinrichtung SW ist über eine weitere Leitung mit einem Daten führenden Punkt der Schaltungsanordnung verbunden. Dieser Daten führende Punkt hängt davon ab, welche der Daten innerhalb der Schaltungsanordnung als Basis für ein Schaltkriterium verwendet werden sollen. Bei der dargestellten Ausführungsform werden als diese Daten die Ausgangsdaten d* der Daten-Verarbeitungseinrichtung Q verwendet, so dass der Ausgang 0 der Daten-Verarbeitungseinrichtung mit dem Eingang der Schalteinrichtung SW verbunden ist.

Die einzelnen Komponenten der Schaltungsanordnung sind insbesondere derart ausgelegt, dass ein Verfahren gemäß Fig. 2 und/oder Fig. 3 mit diesen durchführbar ist.

Gemäß einem einfachen Verfahrensablauf, welcher in Fig. 2 grob skizziert ist, werden in einem ersten Verfahrensschritt S0 Variablen n, m, s, t vorbelegt, welche beispielsweise in dem Speicher M gespeichert werden. Nachfolgend wird in einem Eingabeschritt S1 eine Datenvariable s mit dem aktuell zu erfassenden bzw. zu berücksichtigenden Datenwert der Daten d; d*; d° belegt. In einem nachfolgenden Vergleich S2 wird geprüft, ob der Wert der Datenvariable s kleiner oder gleich einem Schwellenwert t ist, wobei der Schwellenwert t bei der Vorbelegung der Variablen fest vorlegbar oder abhängig von Betriebsbedingungen variabel änderbar ausgestaltet sein kann. Im Vergleich des Vergleichsergebnisses, dass die Datenvariable kleiner oder gleich dem Schwellenwert t ist, wird ein ursprünglich mit Null vorbelegter. Laufindex m um 1 addiert S3. In einem weiteren Vergleichsschritt S4 wird überprüft, ob der Wert des Laufindexes m größer oder gleich einer Mindestanzahl n von Daten d; d*; d° ist, welche als Schaltkriterium kleiner dem Schwellenwert t sein sollen. Der Laufindex m entspricht somit einem Zählerwert des Zählers Z. Falls der Laufindex m kleiner als die Mindestanzahl n ist, wird zum Eingabeschritt S1 zur Eingabe eines nachfolgenden Datenwerts der Daten d; d*; d° zurückgeschritten. Falls der Laufindex m größer oder gleich der Mindestanzahl n ist, wird der Rauschformer H ausgeschaltet, zurückgesetzt bzw. in einen inaktiven Zustand versetzt S5. Dies erfolgt insbesondere durch das Erzeugen des Schaltsignals sw, welches dem Rauschformer H angelegt wird. Nach dem Rücksetzen wird wiederum zum Eingabeschritt S1 zurückgeschritten, um einen nachfolgenden Datenwert der Daten d; d*; d einzugeben und zu erfassen. Falls beim ersten Vergleichsschritt S2 festgestellt wird, dass die aktuelle Datenvariable s, d. h. der aktuell erfasste Datenwert der Daten d; d*; d° größer dem Schwellenwert c ist, wird der Laufindex m auf Null gesetzt, d. h. der Zähler Z zurückgesetzt S6.

Dieses Verfahren, welches beispielsweise in einer solchen Schalteinrichtung SW durchgeführt wird, prüft somit, ob eine der Mindestanzahl n entsprechende Abfolge aufeinanderfolgender Daten d; d*; d° einer Datenfolge mit allen Werten aufeinanderfolgend unterhalb oder auf dem Schwellenwert t liegt. Falls ja, wird der Rauschformer H inaktiviert. Erste Versuche zeigten, dass mit zunehmend größerer Mindestanzahl n eine zunehmend stärkere Reduzierung des Schaltgeräusches beim Inaktivieren bzw. Ausschalten oder Rücksetzen des Rauschformers H erreichbar ist. Abhängig von der erforderlichen oder gewünschten Reduzierung des Schaltgeräusches wird daher die Mindestanzahl n je nach Einsatzzweck und Bedarf vorgegeben. Insbesondere ist eine variable Vorgabe der Mindestanzahl n möglich, um eine Anpassung im Fall geänderter Betriebsbedingungen vornehmen zu können. Auch der Schwellenwert t ist entweder fest vorgebbar oder variabel anpassbar, letzteres um eine Anpassung an geänderte Betriebsbedingungen oder momentane Anforderungen vornehmen zu können. Insbesondere kann der Schwellenwert t theoretisch auch auf Null gesetzt werden, wobei die Festlegung eines geeigneten Schwellenwerts vorzugsweise abhängig von den momentanen Bedingungen erfolgt.

Gemäß einer alternativen Ausführungsform kann auch berücksichtigt werden, dass in einer Abfolge aus aufeinanderfolgenden Daten d, welche kein eigentliches reales Nutz-Eingangssignal repräsentieren, Ausreißer enthalten sind, welche als Einzelwerte den Schwellenwert t überschreiten, obwohl sie ebenfalls keine Nutz-Eingangsdaten repräsentieren. Zur Vermeidung einer unmittelbaren Reaktivierung des Rauschformers H kann daher vorgesehen werden, dass innerhalb einer unmittelbaren Abfolge aus Daten eine bestimmte Anzahl einzelner Ausreißer den Schwellenwert t überschreiten dürfen.

Fig. 3 zeigt ein alternatives Verfahren, welches auch mit dem Verfahren gemäß Fig. 2 kombinierbar ist. Gemäß diesem Verfahren erfolgt das Schalten des Rauschformers H in den inaktiven Zustand dann, wenn eine der Mindestanzahl n entsprechende Abfolge von Daten d; d*; d° einem konstanten Wert entspricht oder innerhalb eines Schwellenbereichs um einen konstanten Wert herum liegt. Der Schwellenwert t gibt entsprechend die Grenze für den Schwellenbereich an.

In einem ersten Schritt S10 wird wiederum eine Vorbelegung von Variablen n, m, t, s, sₒ vorgenommen. Soweit gleiche Bezugszeichen bzw. Variablenkennungen verwendet werden, wird auf gleiche bzw. auf entsprechende Komponenten und Variablen gemäß des Verfahrens aus Fig. 2 Bezug genommen.

In einem nachfolgenden Eingabeschritt S11 werden die erfassten Daten d; d*; d° eingegeben und dem Wert einer Datenvariablen s zugewiesen. Zuvor wird der ursprüngliche Wert der Datenvariablen s in einer Alt-Datenvariablen sₒ gesichert. In einem nachfolgenden Vergleichsschritt S12 wird eine Differenz zwischen dem Wert der Datenvariablen s und dem Wert der Alt-Datenvariablen sₒ gebildet und der Betragswert der Differenz mit dem Schwellenwert bzw. Schwellenbereich t verglichen. Ist der Differenzwert kleiner dem Schwellenwert t, wird in einem nachfolgenden Schritt S13 der Laufindex m um 1 erhöht. Nachfolgend wird in einem zweiten Vergleichsschritt S14 geprüft, ob der Laufindex m kleiner oder gleich der Mindestanzahl n ist. Falls nein, erfolgt ein Rücksprung zum Eingabeschritt S1. Falls ja, erfolgt wiederum ein Rücksetzen S15 des Rauschformers H, insbesondere ein Ausschalten durch Anlegen des Schaltsignals sw an den Rauschformer H Nachfolgend erfolgt ein Rücksprung zum Eingabeschritt S11. Falls beim ersten Vergleichsschritt S12 festgestellt wird, dass die Differenz den Schwellenwert t überschreitet, erfolgt ein Rücksetzen des Laufindex m und ggf. der Datenvariablen s, sₒ in einem nachfolgenden Schritt S16, bevor zum Eingabeschritt S11 zurückgesprungen wird.

Gemäß einer alternativen Ausgestaltung, welche mit gestrichelten Pfaden und Symbolen skizziert ist, umfasst ein besonders bevorzugtes Verfahren zusätzlich die Möglichkeit eines Ausblendens von Werten. Das Ausblenden wird beispielsweise verwendet, wenn konstante Werte oder in entsprechender Weise bei einem Verfahren gemäß Fig. 2 Werte mit einem zu hohen Wert für ein Inaktivieren des Rauschformers H vorliegen und diese Werte über eine Reduzierungsanzahl o von aufeinanderfolgenden Daten d; d*; d° allmählich auf einen Wert reduziert werden sollen, welcher ein Inaktivieren mit ausreichend geringem restlichen Schaltgeräusch ermöglicht. Bei diesem Verfahrensablauf wird beispielsweise zusammen mit dem Schritt S13 zusätzlich zu der Erhöhung des Laufindexes m eine Hilfs-Datenvariable a um den aktuellen Wert der Datenvariable s erhöht. Nach der Feststellung, dass der Laufindex m größer oder gleich der Mindestanzahl n ist S14, wird vor dem Rücksetzen S15 eine Abfolge weiterer Datenverarbeitungsschritte durchgeführt, bei der zuerst eine weitere Reduzierungsvariable b als ein Reduzierungsfaktor mit dem Wert der Hilfs-Datenvariable a dividiert durch die Reduzierungsanzahl o der Ausblendungsschritte abzüglich einer Anzahl der durchgeführten Ausblendungsschritte 1 dividiert wird. Die Reduzierungsvariable b kann dann zum Multiplizieren mit dem momentan anliegenden Datenwert der Daten d oder einem anderen auszublendenden Wert multipliziert werden S18. Außerdem wird ein Ausblendungslaufindex für die Anzahl der durchgeführten Ausblendungsschritte 1 um 1 erhöht S19. Bei einem nachfolgenden Vergleich S20 wird bestimmt, ob der Ausblendungslaufindex 1 kleiner gleich der Reduzierungsanzahl o, d, h. der Ausblendungsdauer ist. Falls ja, folgt ein Rücksprung zum Eingabeschritt 11. Falls nein, erfolgt ein Übergang zum Schritt S15 des Zurücksetzens bzw. Ausschaltens des Rauschformers H. Nach diesem Schritt erfolgt wiederum ein Rücksprung zum Eingabeschritt S11. Falls beim ersten Vergleichsschritt S12 festgestellt wird, dass die Differenz größer oder gleich dem Schwellenwert t ist, erfolgt beim Zurücksetzen neben dem Zurücksetzen des Laufindex m auch ein Zurücksetzen der Hilfs-Datenvariablen a und des Ausblendungslaufindex 1.

Die Hardware mit der Schaltungsanordnung beziehungsweise die Software mit dem Verfahrensablauf zählen somit kontinuierlich die Anzahl von zusammenhängenden Nullen am Ausgang O der Rauschformerschaltung gemäß der ersten Ausführungsform. Ist ein Abtastwert bzw. Datenwert Null, wird der Zähler Z zurückgesetzt und beginnt von neuem zu zählen. Wenn am Ausgang O eine bestimmte Anzahl n von Nullen am Stück detektiert wurden, löscht ein Zurücksetzimpuls bzw. das Schaltsignal sw daraufhin einmal alle Verzögerungsglieder des Rauschformers H. Da die Eingangsdaten d und die Ausgangsdaten d* zu diesem Zeitpunkt schon Null sind, bleibt der Rauschformer H leer, bis erneut Eingangsdaten d ungleich Null von der digitalen Daten-Verarbeitungseinrichtung Q zugeführt werden. Sobald ein Datenwert der Daten d mit einem Wert größer Null erfasst wird, wird durch das entsprechende Anlegen an den Rauschformer H der Ausgang automatisch wieder freigegeben und außerdem der Zähler Z gelöscht, so dass der Ablauf gemäß dieser besonders einfach skizzierten Ausführungsform von vorne beginnt. Bevorzugt wird jedoch auch eine Ausführungsform, bei dem der Rauschformer H zurückgesetzt wird, sobald der Dateneingang I über eine bestimmte Anzahl von Datenwerten konstant war. Vorteilhafterweise wird als Schaltkriterium berücksichtigt, ob die Ausgangsdatenwerte d* gleich Null oder geringer als ein Schwellenwert t sind. Vorteilhaft ist, die Schaltungsanordnung mit dem eigentlichen Rauschformer H durch eine weitere Schaltungseinrichtung SW zu schalten, beispielsweise über ein konstantes Eingangssignal in den Rauschformer über eine bestimmte Zeitdauer bzw. Anzahl von aufeinanderfolgenden Datenwerten. Vorteilhafterweise ist die Mindestanzahl der als Schaltkriterium heranzuziehenden Daten variabel einstellbar.

Nach der anfänglichen Erkenntnis, dass der Rauschformer sich schaltgeräuschreduziert oder schaltgeräuschfrei abschalten lässt, stellte sich die Frage, ob überhaupt ein konkreter Einschaltbefehl benötigt wird, welcher das Eingangssignal des Rauschformers analysiert und die Detektion von Nullwerten daraufhin bei sehr kleinen Signalpegeln aktiviert. Überlegungen ergaben, dass es völlig egal ist, wie das Eingangssignal aussieht, wenn der Rauschformer klick-frei einschaltet und klick-frei ausschaltet. Die Nullen-Erfassung schaltet autark den Rauschformer aus und ein, wenn eine bestimmte Mindestanzahl von Nullwerten bzw. entsprechenden Werten unter einem Schwellwert am Ausgang detektiert wird. Wenn zudem davon ausgegangen wird, dass eine bestimmte Anzahl von Nullen einer bestimmten Signal-Amplitude zugeordnet werden kann, ist außerdem sichergestellt, dass ab einer bestimmten Mindestanzahl von erfassten Nullwerten das Eingangssignal sehr klein ist.

Um sicher zu stellen, dass der Rauschformer auf jeden Fall ausschaltet, kann vorteilhafterweise die Anzahl der Nullen, die zum Zurücksetzen benötigt werden, kaskadiert werden. Beispielsweise wird mit 64 Nullen gestartet. Wenn der Rauschformer eine bestimmte Zeit lang nicht zurück gesetzt wurde, kann die Anzahl auf das Erfassen von 32 Nullen als Schaltkriterium reduziert werden. Werden nach einer weiteren festgelegten Zeit auch keine 32 Nullen festgestellt werden, wird die Erfassung auf 16 Nullen umgestellt usw.

## Patentansprüche

1. Verfahren zum Reduzieren eines Schaltgeräuschs beim Schalten eines Rauschformers (H),
**dadurch gekennzeichnet, dass**
- das Schalten in einen inaktiven Zustand erst nach dem Erfassen von einer Mindestanzahl (n) von Daten (d; d*; d.°) unterhalb eines Schwellenwerts (t) oder Daten eines bestimmten Wertes oder von einer Mindestanzahl (n) von Daten, welche innerhalb eines Schwellenbereichs um einen bezüglich der Daten zueinander konstanten Wert liegen, durchgeführt wird.

2. Verfahren nach Anspruch 1 zum Reduzieren eines Schaltgeräusches beim Schalten eines Rauschformers (H), bei dem
- an einen Eingang (I) einer Daten-Verarbeitungseinrichtung (Q) angelegte Eingangsdaten (d) durch den Rauschformer (H) verändert werden und
- der Rauschformer (H) fallweise inaktiv geschaltet wird, wobei in Verbindung mit dem Inaktivieren eine Reduzierung des Schaltgeräusches durchgeführt wird,
**dadurch gekennzeichnet, dass**
- zum Reduzieren des Schaltgeräusches das Schalten erst nach dem Erfassen einer vorgegebenen Mindestanzahl (n) von Daten (d; d*, d°) unter dem Schwellenwert (t) oder gleich eines bestimmten Wertes durchgeführt wird.

3. Verfahren nach Anspruch 1 oder 2 zum Reduzieren eines. Schaltgeräusches beim Schalten eines Rauschformers (H), bei dem
- an einen Eingang (I) einer Daten-Verarbeitungseinrichtung (Q) angelegte Eingangsdaten (d) durch den Rauschformer (H) verändert werden und
- der Rauschformer (H) fallweise inaktiv geschaltet wird, wobei in Verbindung mit dem Inaktivieren eine Reduzierung des Schaltgeräusches durchgeführt wird,
**dadurch gekennzeichnet, dass**
- zum Reduzieren des Schaltgeräusches das Schalten erst nach dem Erfassen einer vorgegebenen Mindestanzahl (n) von Daten (d; d*; d°), welche innerhalb eines Schwellenbereichs um einen hinsichtlich einer Folge von Daten zueinander konstanten Wert liegen, durchgeführt wird.

4. Verfahren nach einem vorstehenden Anspruch, bei dem die Mindestansahl (n) variabel vorgegeben wird, insbesondere abhängig von der Art oder Herkunft der Daten (d; d°; d*) und/oder der Schwankungsbreite der Werte aufeinanderfolgender der Daten variabel vorgegeben wird.

5. Verfahren nach einem vorstehenden Anspruch, bei welchem dem Rauschformer (H) vor dem Schalten oder anstelle eines aktiven Schaltens über eine vorgegebene Anzahl von Daten ein separates Signal (sw) zum Inaktivieren zugeführt wird.

6. Verfahren nach einem vorstehenden Anspruch, bei welchem dem Rauschformer (H) vor dem Schalten oder anstelle eines aktiven Schaltens vorverarbeitete Eingangsdaten angelegt werden, wobei die Vorverarbeitung zum allmählichen Reduzieren einer Datenamplitude über eine Anzahl von Daten durchgeführt wird.

7. Verfahren nach einem vorstehenden Anspruch, bei welchem
- nach dem Erfassen einer vorgegebenen Mindestanzahl (n) von Daten (d; d*, d°) am Eingang des Rauschformers (H) unter dem Schwellenwert (t) oder gleich eines bestimmten Wertes eine Erfassung von Ausgangswerten gestartet wird und
- das Schalten und/oder ein Zurücksetzen des Rauschformers ((auf Null)) nach dem Erfassen einer vorgegebenen Mindestanzahl (n) von Daten (d; d*, d°) unter einem Schwellenwert (t) oder gleich eines bestimmten Wertes am Ausgang des Rauschformers (H) durchgeführt wird.

8. Rauchformerschaltung (NS) mit einer Schalteinrichtung zum Schalten eines Rauschformers (H) in einen inaktiven Zustand nach Erfassen eines Schaltkriteriums,
**dadurch gekennzeichnet, dass** die Schalteinrichtung zum Erfassen einer Mindestanzahl (n) von Daten (d; d*; d°) unterhalb eines Schwellenwerts (t) oder gleich eines bestimmten Wertes oder von Daten (d; d*; d°), die innerhalb eines Schwellenbereichs um einen hinsichtlich aufeinanderfolgender Daten zueinander konstanten Wert liegen, als Schaltkriterium ausgelegt ist.

9. Rauschformerschaltung (NS), insbesondere nach Anspruch 8, zum Verändern von Eingangsdaten (d) einer Datenfolge für eine Daten-Verarbeitungseinrichtung (Q) mit
- einem Rauschformer (H) und
- einer Schalteinrichtung (SW) zum Inaktivieren des Rauschformers (H) und zum Reduzieren eines Schaltgeräusches,
**dadurch gekennzeichnet, dass**
- die Schalteinrichtung (SW) einen Zähler (Z) zum Zählen von Daten (d; d*; d°) unterhalb eines Schwellenwerts (t) oder gleich eines bestimmten Pegels aufweist und
- die Schalteinrichtung (SW) zum Inaktivieren des Rauschformers (H) erst nach Erfassen einer vorgegebenen Mindestanzahl (n) der gezählten Daten unterhalb des Schwellenwerts (t) oder gleich eines bestimmten Wertes ausgelegt ist.

10. Rauschformerschaltung (NS), insbesondere nach Anspruch 8 oder 9, zum Verändern von Eingangsdaten (d) einer Datenfolge für eine Daten-Verarbeitungseinrichtung (Q) mit
- einem Rauschformer (H) und
- einer Schalteinrichtung (SW) zum Inaktivieren des Rauschformers (H) und zum Reduzieren eines Schaltgeräusches,
**dadurch gekennzeichnet, dass**
- die Schalteinrichtung (SW) einen Zähler (Z) zum Zählen von Daten (d; d*; d°) innerhalb eines Schwellenbereichs um einen hinsichtlich zueinander benachbarten Daten konstanten Wert aufweist und
- die Schalteinrichtung (SW) zum Inaktivieren des Rauschformers (H) erst nach Erfassen einer vorgegebenen Mindestanzahl (n) der gezählten Daten innerhalb des Schwellenbereichs ausgelegt ist.

11. Rauschformerschaltung nach einem der Ansprüche 8 - 10, bei der die Schalteinrichtung ausgelegt ist, die Mindestanzahl (n) variabel vorzugeben, insbesondere abhängig von der Art oder Herkunft der Daten und/oder abhängig von der Schwankungsbreite der Werte aufeinanderfolgender Daten variabel vorzugeben ausgelegt ist.

12. Rauschformerschaltung nach einem der Ansprüche 8 - 11, bei welcher der Rauschformer (H) einen Eingang zum Zuführen eines separaten Signals (SW) zum Inaktivieren über eine vorgegebene Anzahl von Daten vor dem Schalten aufweist.

13. Rauschformerschaltung nach einem der Ansprüche 8 - 12, bei welcher der Rauschformer ausgelegt ist, vor dem Schalten vorverarbeitete Eingangsdaten aufzunehmen, wobei die vorverarbeiteten Eingangsdaten zum allmählichen Reduzieren einer Datenamplitude über eine vorgegebene Anzahl von Daten ausgelegt sind.

14. Verfahren nach einem der Ansprüche 1 - 7 oder Rauschformerschaltung nach einem der Ansprüche 8 - 13, wobei die erfassten Daten von dem Rauschformer veränderte oder von dem Rauschformer unveränderte Eingangsdaten (d) für die Daten-Verarbeitungseinrichtung (Q) sind.

15. Verfahren bzw. Rauschformerschaltung nach einem vorstehenden Anspruch, wobei die erfassten Daten Ausgangsdaten (d*) der Daten-Verarbeitungseinrichtung (Q) sind.

16. Verfahren bzw. Rauschformerschaltung nach einem vorstehenden Anspruch, wobei die erfassten Daten Rauschformer-Eingangsdaten (d°) am Eingang des Rauschformers (H) sind.

17. Verfahren bzw. Rauschformerschaltung nach Anspruch 15, wobei die erfassten Daten aus Eingangsdaten (d) und Ausgangsdaten (d*) der Daten-Verarbeitungseinrichtung (Q) gebildet werden.

18. Verfahren bzw. Rauschformerschaltung nach einem vorstehenden Anspruch, wobei die Daten-Verarbeitungseinrichtung (Q) ein Digital/Analog-Wandler oder ein Impulsbreiten-Modulations-Wandler ist.

19. Verfahren bzw. Rauschformerschaltung nach einem vorstehenden Anspruch, wobei die Anzahl der erfassten Werte oder Daten kaskadiert reduziert wird, wenn der Rauschformer eine bestimmte Zeit lang nicht zurück gesetzt oder geschaltet wurde.
